# FASCICULE DE BREVET EUROPEEN

(11) **EP 1 840 560 B1**
(45) Date de publication et mention de la délivrance du brevet: **28.12.2011**
(21) Numéro de dépôt: 07105297.1
(22) Date de dépôt: 30.03.2007
(51) Int. Cl.: G01N 21/95, C30B 33/00, C30B 29/06

(54) **Procédé de révélation de défauts cristallins dans un substrat massif**
Verfahren zur Enthüllung von kristallinen Defekten in einem massiven Substrat
Method of revealing crystalline faults in a massive substrate

(30) Priorité: 31.03.2006 FR 0602786
(43) Date de publication de la demande: 03.10.2007
(73) Titulaire: S.O.I.Tec Silicon on Insulator Technologies, 38190 Bernin (FR)
(72) Inventeur: Kononchuck, Oleg, 38000, GRENOBLE (FR); Maleville, Christophe, 38660, LA TERRASSE (FR); Reynaud, Patrick, 38400, SAINT MARTIN D'HERES (FR)
(74) Mandataire: Bomer, Françoise Marie

(56) Documents cités:
- EP-A- 1 158 581
- WO-A-2004/090516
- US-A- 5 961 713
- US-A- 6 146 911
- US-A1- 2002 167 661
- US-A1- 2004 194 692
- US-A1- 2005 064 632
- MORICEAU H ET AL: "A NEW CHARACTERIZATION PROCESS USED TO QUALIFY SOI FILMS" ELECTROCHEMICAL SOCIETY PROCEEDINGS, ELECTROCHEMICAL SOCIETY, PENNINGTON, NJ, US, vol. 99-3, 2 mai 1999 (1999-05-02), pages 173-178, XP001051822 ISSN: 0161-6374

## Description

La présente invention concerne un procédé de révélation de défauts cristallins, présents à l'intérieur d'un substrat massif en silicium.

Ce procédé s'applique plus particulièrement à la révélation des défauts qui existent à l'état latent dans un substrat mais qui n'apparaissent que lorsque ce substrat est recyclé.

L'invention concerne également des substrats présentant une faible densité de défauts et donc particulièrement adaptés aux transfert s multiple s de couches.

Les substrats utilisés dans le domaine de l'électronique, l'optique ou l'opto-électronique, peuvent être fabriqués à partir d'une matière première, obtenue industriellement sous forme de lingot.

Diverses méthodes de tirage de lingots sont bien connues de l'homme du métier. Il s'agit par exemple, de la méthode de tirage de Czochalski (connue sous la dénomination de "tirage CZ"), ou de la méthode de fusion de zone (connue sous l'appellation de "tirage FZ").

Ces diverses méthodes permettent de fournir des lingots de matière brute, ayant des formes variées, et notamment la forme d'un cylindre dont les deux extrémités sont sensiblement coniques.

A titre d'exemple, un lingot de silicium peut présenter une longueur d'environ 1 à 2 mètres.

Ces lingots sont découpés de façon à éliminer leurs extrémités en pointe, puis leur partie centrale cylindrique est tronçonnée en plusieurs tronçons. Chaque tronçon est alors découpé en une pluralité de tranches.

Chaque tranche subit ensuite des étapes de finition, telles que le meulage et le polissage, de façon que ses deux faces opposées soient planes, et des étapes de gravure chimique, de façon à éliminer la zone écrouie lors des étapes précédentes d'enlèvement de matière, ainsi que les poussières et les particules résiduelles.

Dans la suite de la description et des revendications, les tranches ainsi préparées seront dénommées "substrats massifs vierges".

A titre d'exemple, dans un lingot de 300 mm de diamètre, on découpe généralement des tronçons de 20 à 30 cm de long et l'on obtient environ 200 substrats vierges à partir de chaque tronçon.

Dans un lingot de 200 mm de diamètre au moins, on découpe des tronçons de 30 à 40 cm de long environ et l'on tire plus de 200 substrats vierges de chaque tronçon.

Chaque substrat massif en silicium peut ensuite être utilisé dans des procédés de report de couches, par exemple pour l'obtention de substrats connus sous l'acronyme "SOI", d'après la terminologie anglaise de "*Silicon On Insulator*".

Pour mémoire, un substrat de type SOI peut être obtenu par prélèvement d'une couche mince superficielle dans un substrat massif en silicium, dit "donneur", puis report de cette couche sur un substrat dit "receveur", après interposition d'une couche d'oxyde de silicium.

Après un premier prélèvement de couche, le substrat donneur peut être recyclé, c'est-à-dire réutilisé pour y prélever une autre couche mince et la reporter sur un second substrat receveur. Dans la suite de la description et des revendications, un tel substrat sera dénommé "substrat massif recyclé".

Un substrat donneur peut ainsi être recyclé trois ou quatre fois, voire même une dizaine ou une douzaine de fois.

Or, un tel substrat massif peut présenter des défauts cristallins.

Ces défauts cristallins sont par exemple des dislocations, des lacunes qui peuvent être isolées ou former des amas.

Il peut également s'agir d'agglomérations de défauts ponctuels de type interstitiels ou lacunes, ou de fautes d'empilement, de précipités d'oxygène, d'inclusions amorphes ou cristallines de phases étrangères (siliciure, précipité de contamination), ou encore de précipités métalliques.

Les défauts cristallins peuvent, en fonction de leur nombre et de leur localisation sur le substrat, rendre celui-ci impropre à la fabrication ultérieure de composants électroniques.

La qualité des substrats massifs est essentielle, car elle influe directement sur la qualité des couches transférées et donc sur celle des substrats hybrides finaux obtenus, à partir desquels seront fabriqués les composants électroniques.

La demanderesse a constaté que les défauts peuvent être présents sur un substrat massif vierge, et révélés avant la toute première utilisation de celui-ci. Il s'agit par exemple de défauts du type connu sous l'abréviation de "COP" en anglais, pour "*Crystal Originated Particules*" qui signifie "agglomération de lacunes".

Ces défauts de type COPs présents au niveau du substrat massif se retrouvent directement au niveau des couches transférées. Des méthodes ont été mises au point afin de diminuer, voire d'éliminer ce type de défauts. On pourra se référer à ce suj et au document EP 1158581.

Les procédés de tirage CZ des lingots ont également été améliorés, afin d'éviter les COPs ou d'autres types de défauts cristallins.

Toutefois, même en utilisant des lingots améliorés pour la fabrication de substrats vierges, la demanderesse a remarqué qu'il existe encore certains défauts, présents à l'état latent (c'est -à-dire à l'état caché), et qui n'apparaissent qu'ultérieurement, après un recyclage du substrat et fréquemment après trois recyclages de celui-ci. Dans ce dernier cas, ces défauts préexistent, mais sont de petites dimensions et les traitements thermiques répétés, liés aux recyclages successifs, ont pour effet d'accroître leurs dimensions. Ces défauts sont généralement des précipités d'oxygène.

On comprend aisément l'intérêt économique qu'il y aurait à pouvoir prévoir la qualité des substrats massifs, avant de les utiliser dans une chaîne de fabrication, en vue de révéler, de façon anticipée, des défauts qui n'apparaîtront qu'après plusieurs recyclages.

On connaît déjà d'après le document US 2005/0064632, une technique de révélation de défauts, dénommée "méthode de dépôt de cuivre" pour caractériser et choisir des plaquettes adaptées à la fabrication d'un substrat de type SOI.

Cette méthode de révélation consiste à former un film d'oxyde d'une épaisseur prédéterminée à la surface d'une plaquette, puis à en retirer une partie, avant de déposer sur la plaquette, une solution d'électrolytes de cuivre. En appliquant ensuite un courant électrique, on constate que les ions Cu précipitent sous forme de cuivre, aux endroits où la couche d'oxyde est dégradée, ces endroits correspondant aux zones défectueuses de la plaquette située dessous.

Une analyse de la surface permet ultérieurement d'effectuer un tri de ces plaquettes, en fonction de la présence ou non des défauts.

Toutefois, cette technique ne permet pas de détecter les défauts cristallins susceptibles d'apparaître ultérieurement après plusieurs recyclages.

L'invention a pour objectif de résoudre les problèmes précités et de fournir un procédé d'analyse de substrats de silicium massifs, qui permette de révéler, de façon anticipée, des défauts de très petites dimensions, existant à l'état latent et qui n'apparaîtront qu'après plusieurs recyclages de ce substrat, plus précisément après au moins trois recyclages.

Ceci permet d'effectuer un tri, et sur la base des résultats obtenus sur un substrat échantillon issu d'un tronçon donné, d'en tirer des conclusions, par extrapolation, sur la qualité des autres substrats issus de ce même tronçon.

En pratique, de façon avantageuse, après la découpe d'un tronçon, on prélèvera de préférence à chacune de ses extrémités, une tranche (ou substrat) et on leur fera subir le procédé conforme à l'invention.

Au vu des résultats obtenus sur ces deux substrats d'extrémité, on pourra en déduire des informations sur la qualité du tronçon et décider ou non de poursuivre la découpe et la fabrication des substrats vierges, à partir de ce tronçon, ou bien si ces substrats sont déjà fabriqués, décider ou non de les conserver et de les utiliser dans une chaîne de production.

Le procédé conforme à l'invention permet ainsi d'écarter les substrats massifs qui présentent des défauts cristallins sous-jacents, susceptibles ultérieurement de rendre défectueux les composés électroniques qui seraient fabriqués à partir de ceux-ci.

De plus, la qualité d'un substrat massif vierge est fortement liée au type de procédé de tirage selon lequel il a été fabriqué et aux conditions dans lesquelles ce procédé a été mis en oeuvre industriellement.

L'invention a également pour objectif, par l'analyse d'un substrat massif vierge échantillon, de mettre au point le procédé de tirage permettant d'obtenir les substrats ayant les spécificités requises en fonction de l'application finale visée.

L'invention trouve une application particulière dans la présélection de substrats massifs en silicium, vierges, entrant dans un procédé de fabrication de substrat de type SOI, notamment ceux utilisant les techniques de report connues sous la marque Smart Cut^{™}.

Par ailleurs, l'invention permet également, dans une chaîne de fabrication, de tester un substrat massif en silicium, déjà recyclé plusieurs fois et destiné à l'être encore. Ainsi, la qualité d'un substrat massif, qui peut parfois être recyclé jusqu'à une dizaine de fois, peut être contrôlée à intervalles réguliers, par exemple, tous les trois ou quatre recyclages. Si l'on constate que la qualité de ce substrat devient moindre, on peut alors retirer de la chaîne de fabrication, tous les substrats issus du même tronçon.

Enfin, l'invention a pour objectif de fournir un procédé simple à mettre en oeuvre et peu coûteux.

A cet effet, l'invention concerne un procédé selon la revendication 1 de révélation anticipée des défauts cristallins existant à l'état latent dans un substrat massif en silicium et qui n'apparaîtront ultérieurement que si ce substrat est utilisé dans un procédé de prélèvement et de report de couches et recyclé au moins trois fois.

Conformément à l'invention, ce procédé comprend une étape consistant à soumettre ledit substrat massif à un traitement thermique, dit "de révélation", réalisé dans une atmosphère non réductrice, à une température comprise entre 500 et 1300°C environ.

Un tel procédé permet d'analyser des substrats vierges ou déjà recyclés et d'effectuer un contrôle de qualité.

On notera que le substrat échantillon qui aura subi le procédé conforme à l'invention, ne pourra plus être utilisé ultérieurement dans un procédé de report de couches.

Selon d'autres caractéristiques avantageuses et non limitatives de l'invention, prises seules ou en combinaison :
- le traitement thermique de révélation est effectué à l'intérieur d'une enceinte dans laquelle se trouve un mélange gazeux comprenant au moins 10 ppm d'oxygène sur la base de la totalité du volume du mélange gazeux présent dans l'enceinte, de l'argon ou de l'azote ou un mélange des deux, ce traitement étant mis en oeuvre pendant une durée d'au moins 3 minutes ;
- le traitement thermique de révélation est effectué à l'intérieur d'une enceinte dans laquelle se trouve de l'argon ou de l'azote ou un mélange des deux, pendant une durée d'au moins 3 minutes et il est précédé d'une étape d'oxydation sèche et suivi d'une étape de désoxydation dudit substrat massif, de façon à éliminer complètement la couche d'oxyde formée précédemment ;
- le traitement thermique de révélation est réalisé à une température voisine de 950°C, pendant 6 heures environ ;
- le traitement thermique de révélation comprend une oxydation thermique sèche et/ou humide du substrat, effectuée dans une atmosphère contenant, en plus de l'oxygène, éventuellement de l'argon, de l'azote ou un mélange des deux, cette oxydation étant suivie d'une étape de désoxydation, de façon à éliminer complètement la couche d'oxyde formée précédemment ;
- l'oxydation humide du substrat massif est réalisée à une température comprise entre 500°C et 1300°C, pendant une durée de 3 minutes à quelques dizaines d'heures, afin de former une couche d'oxyde de silicium (SiO₂) d'une épaisseur comprise entre 500 et 900 nm ;
- l'oxydation sèche du substrat massif est réalisée à une température comprise entre 500 et 1100°C environ, pendant une durée d'environ 2 à 15 minutes, afin de former une couche d'oxyde de silicium (SiO₂) d'une épaisseur de quelques dizaines de nanomètres ;
- l'oxydation sèche est réalisée à une température voisine de 950°C, pendant 5 minutes environ ;
- la désoxydation est effectuée par un traitement à l'acide fluorhydrique (HF) ;
- après le traitement thermique de révélation des défauts cristallins et l'éventuelle étape de désoxydation, on réalise une étape supplémentaire d'agrandissement des défauts révélés par ledit traitement thermique de révélation ;
- l'étape d'agrandissement des défauts cristallins comprend un traitement thermique rapide de type RTP, à des températures allant de quelques centaines de degrés Celsius à 1300°C environ, pendant une durée comprise entre quelques secondes à quelques minutes ;
- le traitement thermique rapide est de type recuit thermique rapide RTA, réalisé en présence d'argon et/ou d'hydrogène ;
- le traitement thermique rapide est de type oxydation thermique rapide RTO, réalisé en présence d'oxygène ;
- l'étape d'agrandissement des défauts cristallins comprend un traitement thermique dit "de recuit au four par lots", sous une atmosphère de gaz neutre et/ou hydrogène, à des températures de l'ordre de 1100°C à 1250°C, pendant quelques minutes à quelques heures ;
- après l'étape d'agrandissement des défauts cristallins, on dépose, par épitaxie, une couche de silicium de quelques micromètres sur ledit substrat massif, afin de favoriser encore la révélation de ces défauts.

L'invention concerne également un procédé selon la revendication 16 de mesure de la densité de défauts cristallins, dans un substrat massif en silicium, ces défauts étant tels qu'ils apparaîtraient ultérieurement si ce substrat était utilisé ultérieurement dans un procédé de prélèvement et de report de couches et recyclé au moins trois fois.

Conformément à l'invention, ce procédé comprend les étapes suivantes consistant à :
- révéler lesdits défauts cristallins du substrat massif, conformément au procédé précité,
- comptabiliser les défauts cristallins ainsi révélés, par unité de surface, à l'aide d'une installation de comptage, de façon à déterminer la densité de défauts cristallins dudit substrat massif.

De façon avantageuse, l'installation de comptage comprend au moins un microscope et un appareil de comptage ou un microscope à force atomique ou un dispositif d'analyse de surface par laser ou un appareil de tomographie par diffusion lumineuse (LST) ou un microscope à infrarouge à balayage (SIRM).

Par ailleurs, l'invention permet la production d'un substrat massif en silicium destiné à être utilisé ultérieurement dans un procédé de prélèvement et de report de couches et à être recyclé au moins trois fois, ce substrat étant remarquable en ce qu'il comprend une densité de défauts cristallins, révélés par le procédé précité, inférieure à 0,1 défaut par cm².

Un tel substrat trouve une application particulière dans la fabrication de substrats de type SOI.

Enfin, l'invention se rapporte à un procédé de fabrication d'un substrat massif en silicium, issu d'un lingot obtenu par tirage de type Czochalski, qui comprend une étape de révélation anticipée des défauts cristallins, par le procédé précité.

Comme expliqué précédemment, le fait que ce procédé intègre une étape de révélation des défauts conforme à l'invention, permet, après un premier contrôle sur les tronçons de lingots, c'est-à-dire au début du cycle de fabrication des substrats massifs, de déterminer très rapidement si ce cycle doit être poursuivi.

D'autres caractéristiques et avantages de l'invention apparaîtront de la description qui va maintenant en être faite, en référence aux dessins annexés, qui en représentent, à titre indicatif mais non limitatif, un mode de réalisation possible.

Sur ces dessins :

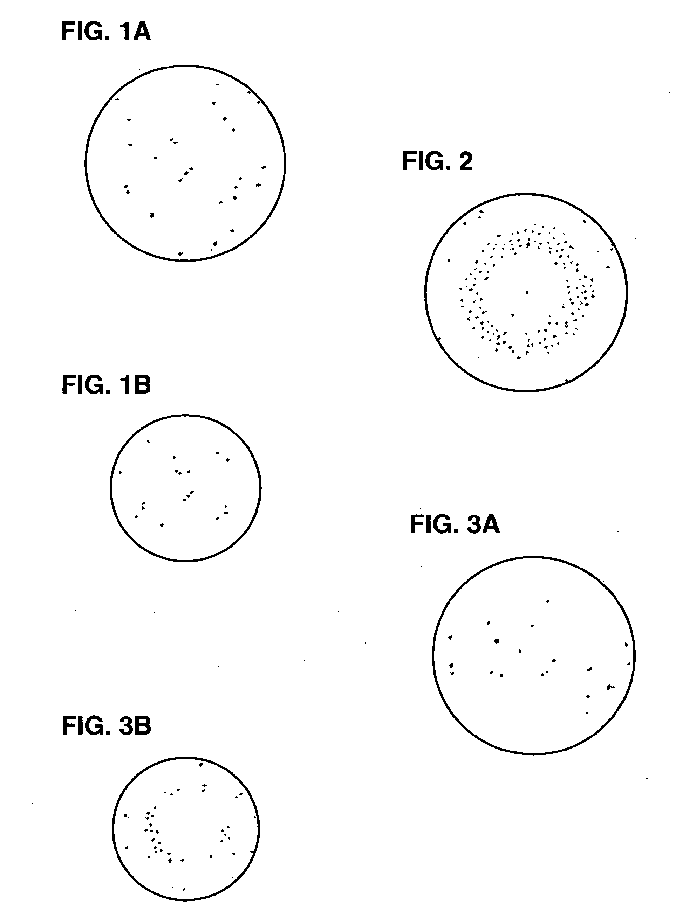

- les figures 1A, 2 et 3A sont des représentations schématiques de vues obtenues par un dispositif d'analyse de surface par laser, commercialisé sous la marque Surfscan SP1, qui représentent la surface de différents substrats massifs en silicium, après un premier traitement de révélation de défauts cristallins, et
- les figures 1B et 3B sont des représentations schématiques de vues obtenues par un dispositif d'analyse de surface par laser, commercialisé sous la marque Surfscan SP1, qui représentent les mêmes substrats que ceux des figures 1A et 3A après un second traitement de révélation de défauts cristallins.

Le procédé d'analyse et de révélation conforme à l'invention comprend plusieurs séries d'étapes qui correspondent à trois niveaux d'analyse de plus en plus poussée d'un substrat massif de silicium, dit "substrat échantillon" dont la qualité est représentative de celle des autres substrats issus du même lingot ou du même tronçon.

Lorsque le premier niveau d'analyse révèle dans ce substrat, un nombre de défauts ou un positionnement de ceux-ci, rédhibitoire pour l'application visée, ce substrat et ceux dont il est représentatif sont écartés.

Lorsque ce premier niveau d'analyse ne révèle aucun ou peu de défauts, le substrat échantillon et témoin est soumis aux étapes de révélation du deuxième niveau d'analyse, voire du troisième niveau, si besoin est.

Ensuite, les défauts cristallins révélés sont comptés par des techniques qui seront décrites ultérieurement.

Ces trois niveaux d'analyse permettent de détecter et révéler des défauts de plus en plus petits.

Plus précisément, les défauts ne deviennent visibles qu'au dessus du seuil de détection des appareils de comptage des défauts qui est actuellement de 0,13 µm. Les différents niveaux d'analyse ont donc pour objectif d'agrandir les défauts présents jusqu'à ce qu'ils atteignent cette dimension minimale.

### Premier niveau d'analyse :

Le substrat massif est soumis à un traitement thermique dit "de révélation", réalisé dans une atmosphère non réductrice, à une température comprise entre 500°C et 1300°C environ, de préférence entre 900°C et 1300°C.

Un substrat massif, qu'il soit vierge ou qu'il ait déjà été recyclé, contient de l'oxygène. Si le traitement thermique est effectué entre 500°C et 900°C environ, l'oxygène présent s'agglomère sous forme de nuclei. Si l'augmentation de la température est poursuivie jusqu'à des températures comprises entre 900°C et 1300°C, ceci permet la croissance des nuclei et leur transformation en précipités de grosse taille, qui pourront ensuite être observés et comptés.

Selon un premier mode de réalisation de l'invention, ce traitement est effectué à l'intérieur d'une enceinte dans laquelle se trouve un mélange gazeux comprenant au moins 10 ppm d'oxygène sur la base de la totalité du volume du mélange gazeux présente dans l'enceinte, de l'argon, de l'azote ou un mélange des deux gaz, pendant au moins 3 minutes à quelques dizaines d'heures, de préférence à 950°C environ, pendant 6 heures.

La durée de traitement thermique sera adaptée en fonction de la température appliquée, mais également en fonction de la nature du substrat, à savoir un substrat vierge ou recyclé.

La durée du traitement thermique sera d'autant plus grande que le taux de recyclage prévu du substrat sera important. Ainsi, à titre d'exemple, un substrat représentatif de substrats que l'on envisage de recycler huit fois sera chauffé plus longtemps que si l'on envisageait seulement trois recyclages.

Le procédé de l'invention permet de garantir que les substrats pourront être recyclés au moins trois fois de suite, au plus douze, préférentiellement six, sans que des défauts n'apparaissent dans les couches prélevées.

De façon optionnelle, les substrats massifs en silicium peuvent être soumis avant tout traitement thermique, à une légère oxydation (oxydation sèche), afin de générer une fine couche d'oxyde de silicium (SiO₂), de l'ordre d'une dizaine de nanomètres, pour avoir un état de surface le plus parfait possible.

Dans ce cas, la présence d'au moins 10 ppm (parties par millions) d'oxygène pendant le traitement de révélation, n'est pas indispensable.

Cette oxydation sèche est effectuée à une température comprise entre 500°C et 1100°C environ, pendant une durée de 2 minutes à 15 minutes environ, de préférence à une température voisine de 950°C, pendant 5 minutes environ.

Si l'on a formé une couche d'oxyde, après le traitement thermique, on procède à la désoxydation complète du substrat, par exemple avec de l'acide fluorhydrique (HF), avant de comptabiliser les défauts.

De façon avantageuse, on utilise une solution aqueuse d'acide fluorhydrique à 8 %, pendant environ 15 minutes.

Cette étape permet de graver sélectivement la couche d'oxyde et d'accéder à la surface de silicium à analyser. Les conditions de désoxydation (concentration, durée du traitement) avec l'acide HF sont adaptées en fonction de l'épaisseur de la couche à éliminer.

Selon un second mode de réalisation de l'invention, le traitement thermique de révélation est une oxydation thermique sèche et/ou humide du substrat, effectuée dans une atmosphère contenant, en plus de l'oxygène, éventuellement de l'argon, de l'azote ou un mélange des deux.

L'oxydation humide permet de former une couche d'oxyde de silicium (SiO₂) épaisse (de l'ordre de quelques centaines de nanomètres). Selon l'épaisseur finale désirée, les paramètres de température et de durée de l'oxydation seront adaptés.

Dans une application particulière de l'invention, on ajuste les paramètres afin d'obtenir une couche de 500 à 900 nanomètres.

Lorsqu'une oxydation sèche est réalisée, elle l'est dans les mêmes conditions que celles décrites précédemment. Elle peut être effectuée avant et/ou après l'oxydation humide.

Cette étape d'oxydation thermique permet de faire apparaître les zones du substrat massif qui risquent de conduire ultérieurement à des défauts de petite ou moyenne taille, au niveau de l'interface entre le silicium massif et la couche d'oxyde de silicium dans un substrat SOI.

Cette oxydation peut être réalisée en une seule étape, mais également par plusieurs oxydations successives, pour obtenir au final le même résultat.

A titre d'exemple purement illustratif, on peut réaliser une oxydation à une étape, entre 800°C et 1000°C, pendant 6 heures, pour former une couche d'oxyde de silicium de 730 nm ou une oxydation en sept étapes, à 950°C, en formant à chaque fois, en 1 heure, une couche d'oxyde de silicium de 140 nm.

Une étape finale de désoxydation est ensuite réalisée dans les mêmes conditions que précédemment.

A l'issue de ce premier niveau d'analyse, les défauts révélés présentent un diamètre moyen d'au moins 0,13 µm. Ils peuvent alors être observés et comptés.

Les défauts qui sont inférieurs à 0,13 µm ne sont pas visibles.

De ce fait, les substrats qui ne présentent pas de défauts sont soumis aux étapes de révélation de deuxième niveau, voire même de troisième niveau, afin de vérifier si réellement, ils ne comportent pas de défauts ou si ceux-ci sont encore trop petits pour être révélés.

### Deuxième niveau d'analyse :

Celui-ci consiste à agrandir les défauts non révélés par le précédent traitement thermique de révélation.

Deux modes d'agrandissement de ces défauts peuvent être utilisés, ils vont maintenant être décrits.

### Procédé de traitement thermique rapide :

Ce procédé, connu sous l'acronyme anglais de "RTP" ("*Rapid Thermal Process*") consiste à placer le substrat à analyser dans un four de recuit rapide.

Ce type de four est commercialisé par exemple par la société Applied Materials, sous la marque Centura. Des rampes de montée et de descente en température à des vitesses supérieures à plusieurs dizaines de degrés Celsius par seconde, permettent de chauffer le substrat à des températures allant de quelques centaines de degrés Celsius, de préférence environ 300°C, jusqu'à 1300°C environ, avec des durées de traitement de quelques secondes à quelques minutes.

Parmi les traitements de type RTP, on distingue celui connu sous l'acronyme "RTA" d'après l'expression anglaise de "*Rapid Thermal Annealing*" qui signifie "recuit thermique rapide" et celui connu sous l'acronyme "RTO" d'après l'expression anglaise de "*Rapid Thermal Oxidation*" qui signifie "oxydation thermique rapide".

Le RTA est effectué en présence d'argon et/ou d'hydrogène, le RTO en présence d'oxygène.

### Procédé de traitement thermique en lots :

Ce procédé de recuit thermique au four, par lots, connu sous la terminologie anglaise de "*Batch anneal*", se fait soit sous une atmosphère de gaz neutre (argon ou azote) et/ou hydrogène, à des températures de l'ordre de 1100°C à 1250°C, pendant quelques minutes à quelques heures.

A l'issue de ce deuxième niveau d'analyse, les défauts révélés présentent un diamètre moyen supérieur à 0,13 micromètres (0,13 µm). Ils peuvent alors être observés et comptés.

Les défauts qui sont inférieurs à 0,13 µm ne sont par contre pas visibles.

Les substrats qui ne présentent pas de défauts visibles sont alors soumis aux étapes de révélation de troisième niveau.

### Troisième niveau d'analyse :

Il s'agit d'une épitaxie, destinée à faire croître une couche de silicium sur le substrat massif pour agrandir les défauts de trop petite taille. L'épaisseur de la couche de silicium ainsi déposée est de l'ordre de quelques micromètres.

Cette épitaxie peut être réalisée par exemple avec un précurseur de type dichlorosilane.

La couche épitaxiée reproduit les défauts révélés précédemment, notamment par reproduction des agencements de maille du substrat à analyser situé dessous.

Après les différents niveaux de révélation, on procède à la mesure de la densité des défauts cristallins précédemment révélés, par unité de surface, à l'aide d'une installation de comptage.

L'installation de comptage peut prendre la forme de tout équipement susceptible de détecter des défauts sur un substrat massif en silicium.

Selon différentes variantes, l'installation de comptage comprend un microscope et un appareil de comptage ou un microscope à force atomique (connu sous l'abréviation AFM, pour "*Atomic Force Microscopy*" en terminologie Anglosaxonne) ou encore un dispositif d'analyse de surface par laser permettant la détection des particules et des défauts de surface, voire même l'analyse de la rugosité.

Ces différentes installations sont décrites brièvement ci-après.

L'installation de comptage peut comprendre un microscope optique qui permet de détecter les défauts cristallins ainsi révélés et des moyens de comptage.

Dans leur plus simple expression, ces moyens de comptage peuvent être un opérateur qui, à partir de l'observation qu'il fera d'une zone ou d'une multitude de zones de l'échantillon et du nombre de défauts qu'il aura détecté, en déduira la densité de défauts cristallins.

Ces moyens de comptage peuvent également être automatisés, en associant par exemple au microscope, un système de détection automatique des défauts cristallins révélés, par exemple par traitement d'image, ou encore un système d'automatisation du déplacement de l'échantillon, de manière à définir la surface observée.

Un exemple de dispositif d'analyse de surface par laser utilisable est un équipement connu sous la marque "Surfscan" (par exemple modèle 6200, ou SP1), commercialisé par la société KLA-Tencor. Ce type d'équipement peut non seulement fournir le nombre de défauts révélés, mais également leur répartition géographique sur chaque plaque, grâce à l'établissement de cartographies de défauts.

L'installation de comptage peut également comprendre des appareils permettant, non seulement de compter les défauts de surface, mais d'en obtenir une analyse en profondeur, c'est-à-dire d'obtenir des informations sur leur volume.

Il s'agit d'un appareil de tomographie par diffusion lumineuse, connu sous l'acronyme "LST" d'après la terminologie anglaise de "*Light Scattering Tomography*" ou d'un microscope à infrarouge à balayage, connu sous l'acronyme "SIRM", d'après la terminologie anglaise de "*Scanning Infrared Microscopy*".

Les figure s sont des représentations schématiques de vues de l'état de surface de plaques de silicium de diamètre de 300 mm, obtenues par le dispositif Surfscan SP1 précité, respectivement après un premier, puis un second traitement de révélation de défauts.

Plus précisément, le premier traitement a consisté en un traitement thermique de l'ordre de 950°C pendant 6 heures, en présence d'oxygène et d'hydrogène et le second traitement à déposer par épitaxie, sur chaque plaque de silicium, une couche de silicium de 2 µm d'épaisseur.

Les plaques seront qualifiées de bonne ou de mauvaise qualité, en fonction du nombre de défauts présents à la surface d'une plaque (substrat), mais aussi et surtout suivant la position cartographique des défauts sur ladite plaque.

Ainsi, par exemple, la plaque de la figure 1A est de bonne qualité. On peut constater sur la figure 1B que même après l'épitaxie complémentaire, le nombre de défauts est peu important et réparti uniformément.

La plaque de la figure 2 quant à elle, ne passe pas la sélection. La couronne de défauts est apparente après le premier niveau d'analyse conforme à l'invention.

Enfin, pour ce qui concerne la plaque des figures 3A et 3B, cette dernière ne sera pas choisie pour être intégrée dans un processus de fabrication de SOI. En effet, après l'épitaxie, on constate la présence d'un faible nombre de défauts, mais malheureusement concentrés sur une zone en couronne.

## Revendications

1. Procédé de révélation anticipée de défauts cristallins existant à l'état latent dans un substrat massif en silicium, c'est-à-dire n'apparaissant que lorsque ce substrat est utilisé dans un procédé de prélèvement et de report de couches et est recyclé au moins trois fois, ce procédé étant **caractérisé en ce qu'**il comprend une étape consistant à :
- soumettre ledit substrat massif à un traitement thermique dit "de révélation", réalisé dans une atmosphère non réductrice, à une température comprise entre 500 et 1300°C environ.

2. Procédé selon la revendication 1, **caractérisé en ce que** le traitement thermique de révélation est effectué à l'intérieur d'une enceinte dans laquelle se trouve un mélange gazeux comprenant au moins 10 ppm d'oxygène sur la base de la totalité du volume du mélange gazeux présent dans l'enceinte, de l'argon ou de l'azote ou un mélange des deux, ce traitement étant mis en oeuvre pendant une durée d'au moins 3 minutes.

3. Procédé selon la revendication 1, **caractérisé en ce que** le traitement thermique de révélation est effectué à l'intérieur d'une enceinte dans laquelle se trouve de l'argon ou de l'azote ou un mélange des deux, pendant une durée d'au moins 3 minutes et **en ce qu'**il est précédé d'une étape d'oxydation sèche et suivi d'une étape de désoxydation dudit substrat massif, de façon à éliminer complètement la couche d'oxyde formée précédemment.

4. Procédé selon la revendication 2 ou 3, **caractérisé en ce que** le traitement thermique de révélation est réalisé à une température voisine de 950°C, pendant 6 heures environ.

5. Procédé selon la revendication 1, **caractérisé en ce que** le traitement thermique de révélation comprend une oxydation thermique sèche et/ou humide du substrat, effectuée dans une atmosphère contenant, en plus de l'oxygène, éventuellement de l'argon, de l'azote ou un mélange des deux, cette oxydation étant suivie d'une étape de désoxydation, de façon à éliminer complètement la couche d'oxyde formée précédemment.

6. Procédé selon la revendication 5, **caractérisé en ce que** l'oxydation humide du substrat massif est réalisée à une température comprise entre 500°C et 1300°C, pendant une durée de 3 minutes à quelques dizaines d'heures, afin de former une couche d'oxyde de silicium (SiO₂) d'une épaisseur comprise entre 500 et 900 nm.

7. Procédé selon la revendication 3 ou 5, **caractérisé en ce que** l'oxydation sèche du substrat massif est réalisée à une température comprise entre 500 et 1100°C environ, pendant une durée d'environ 2 à 15 minutes, afin de former une couche d'oxyde de silicium (SiO₂) d'une épaisseur de quelques dizaines de nanomètres.

8. Procédé selon la revendication 7, **caractérisé en ce que** l'oxydation sèche est réalisée à une température voisine de 950°C, pendant 5 minutes environ.

9. Procédé selon la revendication 3 ou 5, **caractérisé en ce que** la désoxydation est effectuée par un traitement à l'acide fluorhydrique (HF).

10. Procédé selon l'une quelconque des revendications précédentes, **caractérisé en ce qu'**après le traitement thermique de révélation des défauts cristallins et l'éventuelle étape de désoxydation, on réalise une étape supplémentaire d'agrandissement des défauts révélés par ledit traitement thermique de révélation.

11. Procédé selon la revendication 10, **caractérisé en ce que** l'étape d'agrandissement des défauts cristallins comprend un traitement thermique rapide de type RTP, à des températures allant de quelques centaines de degrés Celcius à 1300°C environ, pendant une durée comprise entre quelques secondes à quelques minutes.

12. Procédé selon la revendication 11, **caractérisé en ce que** le traitement thermique rapide est de type recuit thermique rapide RTA, réalisé en présence d'argon et/ou d'hydrogène.

13. Procédé selon la revendication 11, **caractérisé en ce que** le traitement thermique rapide est de type oxydation thermique rapide RTO, réalisé en présence d'oxygène.

14. Procédé selon la revendication 10, **caractérisé en ce que** l'étape d'agrandissement des défauts cristallins comprend un traitement thermique dit "de recuit au four par lots", sous une atmosphère de gaz neutre et/ou hydrogène, à des températures de l'ordre de 1100°C à 1250°C, pendant quelques minutes à quelques heures.

15. Procédé selon l'une des revendications 10 à 14, **caractérisé en ce qu'**après l'étape d'agrandissement des défauts cristallins, on dépose, par épitaxie, une couche de silicium de quelques micromètres sur ledit substrat massif, afin de favoriser encore la révélation de ces défauts.

16. Procédé de mesure de la densité de défauts cristallins, dans un substrat massif en silicium, ces défauts étant tels qu'il apparaîtraient ultérieurement si ce substrat était utilisé ultérieurement dans un procédé de prélèvement et de report de couches et recyclé au moins trois fois, **caractérisé en ce qu'**il comprend les étapes suivantes consistant à :
- révéler lesdits défauts cristallins du substrat massif, conformément au procédé selon l'une quelconque des revendications 1 à 15,
- comptabiliser les défauts cristallins ainsi révélés, par unité de surface, à l'aide d'une installation de comptage, de façon à déterminer la densité de défauts cristallins dudit substrat massif.

17. Procédé selon la revendication 16, **caractérisé en ce que** l'installation de comptage comprend un microscope et un appareil de comptage.

18. Procédé selon la revendication 16, **caractérisé en ce que** l'installation de comptage comprend un microscope à force atomique.

19. Procédé selon la revendication 16, **caractérisé en ce que** l'installation de comptage comprend un dispositif d'analyse de surface par laser.

20. Procédé selon la revendication 16, **caractérisé en ce que** l'installation de comptage comprend un appareil de tomographie par diffusion lumineuse (LST).

21. Procédé selon la revendication 16, **caractérisé en ce que** l'installation de comptage comprend un microscope à infrarouge à balayage (SIRM).

## Claims

1. A method of pre-emptively revealing crystalline defects existing in the latent state in a bulk silicon substrate, i.e. only appearing when this substrate is used in a method of lifting and transferring layers and is recycled at least three times, said method being **characterized in that** it comprises a step consisting in:
subjecting said bulk substrate to a heat treatment termed a "revealing heat treatment", that is carried out in a non-reducing atmosphere at a temperature in the range from about 500°C to 1300°C.

2. A method according to claim 1, **characterized in that** the revealing heat treatment is carried out in a vessel containing a gas mixture comprising at least 10 ppm of oxygen based on the whole volume of the gas mixture present in the vessel, argon or nitrogen, or a mixture of both, said treatment being carried out for a period of at least 3 minutes.

3. A method according to claim 1, **characterized in that** the revealing heat treatment is carried out in a vessel containing argon or nitrogen, or a mixture of both, for a period of at least 3 minutes, and **in that** it is preceded by a dry oxidation step and followed by a step of deoxidizing said bulk substrate to completely eliminate the previously-formed oxide layer.

4. A method according to claim 2 or claim 3, **characterized in that** the revealing heat treatment is carried out at a temperature close to 950°C for about 6 h.

5. A method according to claim 1, **characterized in that** the revealing heat treatment comprises dry and/or wet thermal oxidation of the substrate carried out in an atmosphere optionally containing argon, nitrogen, or a mixture of both in addition to oxygen, said oxidation being followed by a deoxidation step to completely eliminate the previously-formed oxide layer.

6. A method according to claim 5, **characterized in that** wet oxidation of the bulk substrate is carried out at a temperature in the range 500°C to 1300°C for a period of 3 minutes to a few tens of hours, to form a layer of silicon oxide (SiO₂) with a thickness in the range 500 nm to 900 nm.

7. A method according to claim 3 or claim 5, **characterized in that** dry oxidation of the bulk substrate is carried out at a temperature in the range from about 500°C to 1100°C for a period of about 2 minutes to 15 minutes, to form a layer of silicon oxide (SiO₂) with a thickness of a few tens of nanometers.

8. A method according to claim 7, **characterized in that** dry oxidation is carried out at a temperature of close to 950°C for about 5 minutes.

9. A method according to claim 3 or claim 5, **characterized in that** deoxidation is carried out by means of a hydrofluoric acid (HF) treatment.

10. A method according to any preceding claim, **characterized in that** after the heat treatment to reveal crystalline defects and the optional deoxidation step, an additional step is carried out of enlarging the defects revealed by said revealing heat treatment.

11. A method according to claim 10, **characterized in that** the step of enlarging the crystalline defects comprises a RTP type rapid heat treatment at temperatures from a few hundred degrees Celsius to about 1300°C for a period in the range from a few seconds to a few minutes.

12. A method according to claim 11, **characterized in that** the rapid heat treatment is of the rapid thermal anneal (RTA) type carried out in the presence of argon and/or hydrogen.

13. A method according to claim 11, **characterized in that** the rapid heat treatment is of the rapid thermal oxidation (RTP) type carried out in the presence of oxygen.

14. A method according to claim 10, **characterized in that** the step of enlarging the crystalline defects comprises a heat treatment termed a "batch furnace annealing" in a neutral gas and/or hydrogen atmosphere at temperatures of the order of 1100°C to 1250°C for a few minutes to a few hours.

15. A method according to any one of claims 10 to 14, **characterized in that** after the step of enlarging the crystalline defects, a layer of silicon a few micrometers thick is deposited on said bulk substrate by epitaxy to further promote the revealing of theses defects.

16. A method of measuring the crystalline defect density in a bulk silicon substrate, said defects being such that they would appear subsequently if this substrate were to be used subsequently in a method of lifting and transferring layers and be recycled at least three times, **characterized in that** it comprises the following steps consisting in:
• revealing said crystalline defects in the bulk substrate in accordance with the method according to any one of claims 1 to 15;
• counting the crystalline defects thus revealed per surface unit, using a counter installation to determine the crystalline defect density in said bulk substrate.

17. A method according to claim 16, **characterized in that** the counter installation comprises a microscope and a counter apparatus.

18. A method according to claim 16, **characterized in that** the counter installation comprises an atomic force microscope.

19. A method according to claim 16, **characterized in that** the counter installation comprises a laser surface analysis device.

20. A method according to claim 16, **characterized in that** the counter installation comprises a light scattering tomography apparatus (LST).

21. A method according to claim 16, **characterized in that** the counter installation comprises a scanning infrared microscope (SIRM).

## Patentansprüche

1. Verfahren für den vorzeitigen Nachweis von kristallinen Defekten, die in latentem Zustand in einem massiven Siliziumsubstrat vorhanden sind, d. h. die nur dann zu Tage treten, wenn das Substrat in einem Verfahren zur Entnahme und Übertragung von Schichten verwendet und mindestens dreimal wiederverwertet wird, wobei das Verfahren **dadurch gekennzeichnet ist, dass** es einen Schritt umfasst, der darin besteht:
- das massive Substrat einer Behandlung, einer sogenannten thermischen "Nachweisbehandlung", auszusetzen, die in einer nicht reduzierenden Atmosphäre bei einer Temperatur zwischen ungefähr 500 und 1.300 °C durchgeführt wird.

2. Verfahren nach Anspruch 1, **dadurch gekennzeichnet, dass** die thermische Nachweisbehandlung im Innern eines Raumes durchgeführt wird, in dem sich ein gasförmiges Gemisch befindet, das mindestens 10 ppm Sauerstoff auf der Basis des Gesamtvolumens des in dem Raum vorhandenen gasförmigen Gemischs, Argon oder Stickstoff oder ein Gemisch dieser beiden enthält, wobei diese Behandlung über einen Zeitraum von mindestens 3 Minuten durchgeführt wird.

3. Verfahren nach Anspruch 1, **dadurch gekennzeichnet, dass** die thermische Nachweisbehandlung im Innern eines Raumes, in dem sich Argon oder Stickstoff oder ein Gemisch dieser beiden befindet, über einen Zeitraum von mindestens 3 Minuten durchgeführt wird, und dass ihr ein Schritt der Trockenoxidation vorangeht und ein Schritt der Desoxidation des massiven Substrats folgt, derart, dass die zuvor gebildete Oxidschicht vollständig entfernt wird.

4. Verfahren nach Anspruch 2 oder 3, **dadurch gekennzeichnet, dass** die thermische Nachweisbehandlung bei einer Temperatur von annähernd 950 °C über ungefähr 6 Stunden durchgeführt wird.

5. Verfahren nach Anspruch 1, **dadurch gekennzeichnet, dass** die thermische Nachweisbehandlung eine thermische Trockenoxidation und/oder Feuchtoxidation des Substrats umfasst, die in einer Atmosphäre durchgeführt wird, die neben Sauerstoff eventuell Argon, Stickstoff oder ein Gemisch dieser beiden enthält, wobei dieser Oxidation ein Schritt der Desoxidation folgt, derart, dass die zuvor gebildete Oxidschicht vollständig entfernt wird.

6. Verfahren nach Anspruch 5, **dadurch gekennzeichnet, dass** die Feuchtoxidation des massiven Substrats bei einer Temperatur zwischen 500 °C und 1.300 °C über einen Zeitraum von 3 Minuten bis zu einigen zehn Stunden durchgeführt wird, um eine Siliziumoxid-Schicht (SiO₂) mit einer Dicke zwischen 500 und 900 nm zu bilden.

7. Verfahren nach Anspruch 3 oder 5, **dadurch gekennzeichnet, dass** die Trockenoxidation des massiven Substrats bei einer Temperatur zwischen ungefähr 500 °C und 1.100 °C über einen Zeitraum von ungefähr 2 bis 15 Minuten durchgeführt wird, um eine Siliziumoxid-Schicht (SiO₂) mit einer Dicke von einigen zehn Nanometern zu bilden.

8. Verfahren nach Anspruch 7, **dadurch gekennzeichnet, dass** die Trockenoxidation bei einer Temperatur von annähernd 950 °C über ungefähr 5 Minuten durchgeführt wird.

9. Verfahren nach Anspruch 3 oder 5, **dadurch gekennzeichnet, dass** die Desoxidation durch eine Behandlung mit Fluorwasserstoffsäure (HF) durchgeführt wird.

10. Verfahren nach einem der vorhergehenden Ansprüche, **dadurch gekennzeichnet, dass** nach der thermischen Behandlung zum Nachweis der kristallinen Defekte und dem eventuellen Schritt der Desoxidation ein zusätzlicher Schritt der Vergrößerung der durch die thermische Nachweisbehandlung nachgewiesenen Defekte durchgeführt wird.

11. Verfahren nach Anspruch 10, **dadurch gekennzeichnet, dass** der Schritt der Vergrößerung der kristallinen Defekte eine schnelle thermische Behandlung vom Typ RTP bei Temperaturen, die von einigen Hundert Grad Celsius bis zu ungefähr 1.300 °C betragen, über einen Zeitraum zwischen einigen Sekunden bis zu einigen Minuten umfasst.

12. Verfahren nach Anspruch 11, **dadurch gekennzeichnet, dass** die schnelle thermische Behandlung vom Typ "schnelles thermisches Glühen" RTA ist, die in Gegenwart von Argon und/oder Wasserstoff durchgeführt wird.

13. Verfahren nach Anspruch 11, **dadurch gekennzeichnet, dass** die schnelle thermische Behandlung vom Typ "schnelle thermische Oxidation" RTO ist, die in Gegenwart von Sauerstoff durchgeführt wird.

14. Verfahren nach Anspruch 10, **dadurch gekennzeichnet, dass** der Schritt der Vergrößerung der kristallinen Defekte eine thermische Behandlung, ein so genanntes "chargenweises Ausglühen im Ofen", in einer Neutralgasatmosphäre und/oder Wasserstoffatmosphäre bei Temperaturen in der Größenordnung von 1.100 °C bis 1.250 °C über einige Minuten bis zu einigen Stunden umfasst.

15. Verfahren nach einem der Ansprüche 10 bis 14, **dadurch gekennzeichnet, dass** nach dem Schritt der Vergrößerung der kristallinen Defekte mittels Epitaxie eine Siliziumschicht von einigen Mikrometern auf das massive Substrat aufgebracht wird, um den Nachweis dieser Defekte weiter zu begünstigen.

16. Verfahren zur Messung der Dichte von kristallinen Defekten in einem massiven Siliziumsubstrat, wobei diese Defekte dergestalt sind, dass sie zu einem späteren Zeitpunkt zu Tage treten, wenn dieses Substrat später in einem Verfahren zur Entnahme und Übertragung von Schichten verwendet und mindestens dreimal wiederverwertet wird, **dadurch gekennzeichnet, dass** es die folgenden Schritte umfasst, die darin bestehen:
- die kristallinen Defekte des massiven Substrats entsprechend dem Verfahren nach einem der Ansprüche 1 bis 15 nachzuweisen,
- die auf diese Weise nachgewiesenen Defekte pro Flächeneinheit mit Hilfe einer Zählvorrichtung zu zählen, derart, dass die Dichte von kristallinen Defekten des massiven Substrats bestimmt wird.

17. Verfahren nach Anspruch 16, **dadurch gekennzeichnet, dass** die Zählvorrichtung ein Mikroskop und einen Zähler umfasst.

18. Verfahren nach Anspruch 16, **dadurch gekennzeichnet, dass** die Zählvorrichtung ein Rasterkraftmikroskop umfasst.

19. Verfahren nach Anspruch 16, **dadurch gekennzeichnet, dass** die Zählvorrichtung eine Vorrichtung zur Oberflächenanalyse mittels Laser umfasst.

20. Verfahren nach Anspruch 16, **dadurch gekennzeichnet, dass** die Zählvorrichtung ein Lichtstreuungstomographie-Gerät (LST) umfasst.

21. Verfahren nach Anspruch 16, **dadurch gekennzeichnet, dass** die Zählvorrichtung ein Scan-Infrarot- Mikroskop (SIRM) umfasst.
